# EUROPÄISCHE PATENTANMELDUNG

(11) **EP 3 355 667 A1**
(43) Veröffentlichungstag der Anmeldung: **01.08.2018**
(21) Anmeldenummer: 17153734.3
(22) Anmeldetag: 30.01.2017
(51) Int. Cl.: H05K 3/34, H01L 23/00, H05K 1/02, H05K 3/28, H05K 3/30

(54) **VERFAHREN ZUR HERSTELLUNG EINER ELEKTRISCHEN SCHALTUNG UND ELEKTRISCHE SCHALTUNG**

(71) Anmelder: Siemens Aktiengesellschaft, 80333 München (DE)
(72) Erfinder: Pfefferlein, Stefan, 90562 Heroldsberg (DE); Bigl, Thomas, 91074 Herzogenaurach (DE)

(57) **Zusammenfassung**

Die Erfindung betrifft ein Verfahren (20) zur Herstellung einer elektrischen Schaltung (2), bei dem ein Schaltungsträger (4) mit einer ersten Kontaktfläche (14) und mit einer zweiten Kontaktfläche (16) bereitgestellt wird. Ein Isolationskörper (26) wird auf den Schaltungsträger (4) aufgebracht, wobei der Isolationskörper (26) die erste Kontaktfläche (14) und die zweite Kontaktfläche (16) zumindest teilweise überdeckt, und wobei der Isolationskörper (26) im Bereich der beiden Kontaktflächen (14, 16) jeweils eine Aussparung (34) aufweist. In den Isolationskörper (26) wird ein fließfähiges elektrisches Leitmedium (44) eingefüllt. Die Erfindung betrifft ferner eine elektrische Schaltung (2) und ein weiteres Verfahren (60) zur Herstellung einer elektrischen Schaltung (2).

## Beschreibung

Die Erfindung betrifft ein Verfahren zur Herstellung einer elektrischen Schaltung sowie eine elektrische Schaltung.

Elektrische Schaltungen weisen meist einen Schaltungsträger auf, an dem elektrische und/oder elektronische Bauteile befestigt sind. Der Schaltungsträger selbst ist meist aus einem glasfaserverstärkten Epoxidharz gefertigt, an dem Leiterbahnen aus Kupfer angebunden oder in dem die Leiterbahnen eingebettet sind. Die elektrischen bzw. elektronischen Bauteile sind elektrisch mit den Leiterbahnen kontaktiert und an diesen befestigt. Dies erfolgt meist mittels einer Oberflächenmontage (SMD-Technik). Hierbei werden Anschlüsse der elektrischen bzw. elektronischen Bauteile oder mit der Leiterbahn verbundene Anschlussflächen mit einer Lotpaste versehen und die Anschlüsse auf die Leiterbahnen gesetzt, wobei das Lot anschließend in einem Wärmeprozess aufgeschmolzen wird. Infolgedessen liegen die Anschlüsse der elektrischen bzw. elektronischen Bauteile im Wesentlichen plan auf der Oberfläche des Schaltungsträgers auf.

Bestimmte Arten von elektrischen bzw. elektronischen Bauteilen, wie insbesondere Leistungshalbleiterschalter, weisen zusätzliche Anschlüsse auf, die im Montagezustand von dem Schaltungsträger beabstandet sind. So sind diese Bauteile meist quaderförmig ausgestaltet, und die dem Schaltungsträger abgewandte Oberfläche weist den oder die Anschlüsse auf oder bildet den oder die Anschlüsse. Zur elektrischen Kontaktierung dieses Anschlusses mit einer der Leiterbahnen wird üblicherweise ein Bonddraht verwendet. Der Bonddraht wird nach Befestigung des Bauteils an dem Schaltungsträger von der Anschlussfläche des Bauelements auf die Anschlussfläche der Leiterbahn geführt.

Um eine ausreichende Stromtragfähigkeit bereitzustellen, insbesondere sofern das Bauteil ein Leistungshalbleiter ist, muss der Bonddraht vergleichsweise massiv oder mehrfach ausgeführt ausgestaltet werden. Infolgedessen ist ein nachträgliches Verformen dieses Bonddrahts im Wesentlichen nicht möglich, ohne dass eine Beschädigung der elektrischen Schaltung auftreten könnte. Hierbei ist es jedoch erforderlich, dass dieser mittels eines Werkzeugs zur Montage gehalten wird. Mittels des Werkzeugs wird der Bonddraht geführt, das sowohl die Bondverbindung durch Ultraschallschweißen erzeugt als auch dem Bonddraht die erforderliche geometrische Ausprägung, den so genannten Loop, ausbildet. Die hierfür benötigte geometrische Ausprägung steht somit auch nach Fertigung der elektrischen Schaltung über, weswegen ein Bauraum vergrößert ist. Zudem kann bei einem Einbau der elektrischen Schaltung oder bei Betrieb ein weiteres Bauteil mechanisch in Kontakt mit dem Bonddraht treten und diesen beispielsweise von der Leiterbahn oder dem Anschluss ablösen. Zudem stellt der Bonddraht eine Induktivität bereit, die bei der Planung und Fertigung der elektrischen Schaltung berücksichtigt werden muss.

Der Erfindung liegt die Aufgabe zugrunde, ein besonders geeignetes Verfahren zur Herstellung einer elektrischen Schaltung sowie eine elektrische Schaltung anzugeben, wobei vorzugsweise eine Temperaturbeständigkeit und insbesondere eine Zuverlässigkeit sowie bevorzugt eine Designflexibilität erhöht und geeigneterweise Herstellungskosten verringert sind.

Hinsichtlich des Verfahrens wird diese Aufgabe durch die Merkmale des Anspruchs 1 sowie durch die Merkmale des Anspruchs 9 und hinsichtlich der elektrischen Schaltung durch die Merkmale des Anspruchs 10 erfindungsgemäß gelöst. Vorteilhafte Weiterbildungen und Ausgestaltungen sind Gegenstand der jeweiligen Unteransprüche.

Das Verfahren dient der Herstellung einer elektrischen Schaltung. Die elektrische Schaltung ist beispielsweise eine Ansteuerschaltung. Insbesondere ist die elektrische Schaltung ein Bestandteil eines Umrichters, wie eines Wechselrichters oder eines Gleichrichters. Vorzugsweise ist die elektrische Schaltung vorgesehen, einen elektrischen Strom von mindestens 1 Ampere (A), 10 Ampere, 20 Ampere, 50 Ampere oder 100 Ampere zu tragen, beispielsweise ist die Stromtragfähigkeit der elektrischen Schaltung kleiner oder gleich 50 kA, 20 kA, 10 kA, 5 kA, 1.000 Ampere, 900 Ampere oder 800 Ampere.

Das Verfahren sieht vor, dass ein Schaltungsträger mit einer ersten Kontaktfläche und mit mindestens einer zweiten Kontaktfläche bereitgestellt wird. Beispielsweise wird der Schaltungsträger gefertigt, oder es wird bereits ein vorkonfektionierter Schaltungsträger verwendet. Der Schaltungsträger ist beispielsweise ein DCB- (Direct Copper Bonding) Substrat oder eine Leiterplatte, das insbesondere ein Substrat aus einem glasfaserverstärkten Epoxidharz oder anderen Substratmaterialien, wie beispielsweise einem spritzgegossenen Schaltungsträger, umfasst. Der Schaltungsträger weist vorzugsweise eine Leiterbahn auf, die beispielsweise an dem Substrat angebunden ist, sofern der Schaltungsträger das Substrat aufweist.

Vorzugsweise befinden sich die beiden Kontaktflächen auf der gleichen Oberflächenseite des Schaltungsträgers. Insbesondere ist die erste Kontaktfläche und/oder die zweite Kontaktfläche zumindest teilweise mittels einer der Leiterbahnen gebildet oder an einer der Leiterbahnen angebunden. Geeigneterweise weist der Schaltungsträger ein elektrisches oder elektronisches Bauteil auf, insbesondere eine Anzahl derartiger Bauteile, das beispielsweise an dem Substrat oder bevorzugt an einer der Leiterbahnen oder an einer der Anschlussflächen angebunden ist, und insbesondere elektrisch mit der Leiterbahn kontaktiert ist. Zum Beispiel wird die zweite Kontaktfläche mit einem Anschluss des elektrischen bzw. elektronischen Bauteils gebildet. Geeigneterweise ist das elektrische bzw. elektronische Bauteil ein Leistungshalbleiter. Vorzugsweise ist das elektrische bzw. elektronische Bauteil ein Halbleiterschalter, insbesondere ein Leistungshalbleiterschalter, wie ein Feldeffekttransistor, beispielsweise ein MOSFET, ein IGBT oder ein GTO. Das elektrische bzw. elektronische Bauteil ist insbesondere mittels Löten, Sintern oder Kleben stoffschlüssig an weiteren Bestandteilen des Schaltungsträgers, wie dem Substrat und/oder einer der Leiterbahnen und/oder einer der Anschlussflächen angebunden.

Der Schaltungsträger ist vorzugsweise im Wesentlichen eben ausgestaltet, wobei beispielsweise mittels der Bauteile bzw. des Bauteils Erhebungen auf der Oberfläche des Schaltungsträgers gebildet sind. Mit Ausnahme der Erhebungen ist der Schaltungsträger bevorzugt im Wesentlichen eben.

Die erste Kontaktfläche und die zweite Kontaktfläche sind vorzugsweise parallel zueinander angeordnet. Mit anderen Worten liegt die erste Kontaktfläche in einer Ebene und die zweite Kontaktfläche liegt in einer weiteren Ebene, wobei die beiden Ebenen zueinander parallel sind. Vorzugsweise sind die beiden Ebenen zueinander beabstandet, sodass die erste Kontaktfläche zu der zweiten Kontaktfläche versetzt ist. Geeigneterweise ist die erste Kontaktfläche zu der zweiten Kontaktfläche elektrisch isoliert.

In einem weiteren Arbeitsschritt wird ein Isolationskörper auf den Schaltungsträger aufgebracht. Der Isolationskörper ist aus einem elektrisch isolierenden Material gefertigt, wie insbesondere einem Kunststoff oder einem Silikon. Ferner wird der Isolationskörper an dem Schaltungsträger bevorzugt angebunden, vorzugsweise an diesem befestigt, beispielsweise stoffschlüssig, sodass die Position des Isolationskörpers bezüglich des Schaltungsträgers stabilisiert ist. Der Isolationskörper ist bevorzugt ein hohl- oder wannenförmiger Körper, wie ein Hohlkörper, und wird derart angeordnet, dass mittels des Isolationskörpers die erste Kontaktfläche und die zweite Kontaktfläche zumindest teilweise überdeckt wird. Mit anderen Worten liegt der Isolationskörper sowohl an der ersten Kontaktfläche als auch an der zweiten Kontaktfläche an und ist folglich in direktem mechanischem Kontakt mit diesen.

Der Isolationskörper weist im Bereich der beiden Kontaktflächen jeweils eine Aussparung auf. Die Aussparungen sind hierbei auf die jeweiligen Kontaktflächen zugerichtet und beispielsweise wird ein Rand der beiden Kontaktflächen oder der Rand zumindest einer der beiden Kontaktflächen, also der ersten Kontaktfläche oder der zweiten Kontaktfläche, mittels des Isolationskörpers abgedichtet, sodass diese Kontaktfläche im Wesentlichen frei von dem Isolationskörper ist. Zumindest wird mittels des hohlkörperartigen Isolationskörpers zum Beispiel ein Raumbereich definiert, mittels dessen die erste Kontaktfläche mit der zweiten Kontaktfläche verbunden ist. Mit anderen Worten ist mittels des Isolationskörpers zumindest teilweise eine Hohlkammer oder ein wannenförmiger Körper bereitgestellt. Der Raumbereich (Hohlkammer) selbst ist bevorzugt mit Luft oder einem sonstigen Gas befüllt, sofern die Herstellung in einer Schutzatmosphäre oder dergleichen erfolgt. Beispielsweise überdeckt die Aussparung lediglich einen Bereich der jeweils zugeordneten Kontaktfläche, wobei insbesondere ein Bereich zwischen der Aussparung und der jeweils zugeordneten Kontaktfläche mittels des Isolationskörpers abgedichtet ist. Zusammenfassend ist der Isolationskörper derart gefertigt, dass dieser nach dem Aufbringen auf den Schaltungsträger die beiden Aussparungen aufweist, die sich im Bereich der beiden Kontaktflächen befinden, und die somit in Kontakt mit den beiden Kontaktflächen sind. Insbesondere sind die beiden Aussparungen hierbei mittels der ersten Kontaktfläche sowie mittels der zweiten Kontaktfläche verschlossen.

In einem weiteren Arbeitsschritt wird in den Isolationskörper ein fließfähiges elektrisches Leitmedium eingeführt. Der Isolationskörper wird hierbei erhalten, sodass die elektrische Schaltung sowohl den Isolationskörper als auch das elektrische Leitmedium aufweist. Das elektrische Leitmedium weist einen vergleichsweise geringen elektrischen Widerstand auf, und umfasst vorzugsweise eine vergleichsweise hohe Dichte frei beweglicher Ladungsträger. Insbesondere ist die Leitfähigkeit des elektrischen Leitmediums größer als 10⁶ S/m (Siemens pro Meter). Das elektrische Leitmedium ist bei der Verarbeitung fließfähig und beispielsweise flüssig. Vorzugsweise ist die Viskosität kleiner als 10⁶ mPa s, 10⁵ mPa s, 10⁴ mPa s, 10³ mPa s, 100 mPa s, 10 mPa s oder 1 mPa s . Zumindest zum Zeitpunkt des Füllens in den Isolationskörper ist das elektrische Leitmedium fließfähig. Geeigneterweise wird das elektrische Leitmedium physikalisch oder chemisch in diesen Zustand versetzt, sodass das elektrische Leitmedium zum Zeitpunkt des Einfüllens in Isolationskörper fließfähig ist. Infolgedessen füllt das elektrische Leitmedium den Isolationskörper zumindest teilweise aus, beispielsweise vollständig, weswegen die erste Kontaktfläche und die zweite Kontaktfläche elektrisch mittels des elektrischen Leitmediums kontaktiert werden, beispielsweise benetzt werden. Vorzugsweise liegt das elektrische Leitmedium mechanisch direkt an den beiden Kontaktflächen an. Insbesondere tritt das elektrische Leitmedium durch die beiden Aussparungen im Bereich der beiden Kontaktflächen teilweise aus, die vorzugsweise mittels der beiden Kontaktflächen verschlossen sind.

Beispielsweise ist das elektrische Leitmedium derart gewählt, dass dieses im Bereich zumindest einer der beiden Kontaktflächen eine Legierung ausbildet, oder zumindest chemisch mit dieser Kontaktfläche reagiert. Insbesondere erfolgt eine stoffschlüssige Verbindung zwischen dem elektrischen Leitmedium und den Kontaktflächen. Beispielsweise erfolgt dies mittels einer sogenannten Bindervernetzung, also einem Binder, der auf die Kontaktfläche im Bereich der Aussparung aufgebracht ist. Insbesondere ist das elektrische Leitmedium fluid, pastös oder ein sogenanntes Preform- oder Einlegeteil.

In einer Ausgestaltungsform der Erfindung wird in den Isolationskörper das elektrische Leitmedium eingefüllt, wobei dieses in dem festen Aggregatszustand vorliegt, also in den Isolationskörper eingelegt. Im Anschluss hieran wird das elektrische Leitmedium aufgeweicht und in den fließfähigen Zustand überführt, sodass dieses den Isolationskörper ausfüllt. Mit anderen Worten setzt sich der Arbeitsschritt des Einfüllens des fließfähigen elektrischen Leitmediums in den Isolationskörper, und somit der Arbeitsschritt des Ausprägens der elektrischen Verbindung, aus zwei Schritten zusammen, wobei zunächst das feste elektrische Leitmedium in den Isolationskörper gelegt wird, wo es anschließend aufgeweicht wird, was insbesondere mittels Erwärmung erfolgt. Hierbei wird das elektrische Leitmedium lediglich auf eine Temperatur erwärmt, die unterhalb der Zersetzungstemperatur des Isolationskörpers ist, sodass dieser nicht beschädigt wird. Das elektrische Leitmedium füllt infolgedessen den Isolationskörper im Wesentlichen vollständig aus, sodass die beiden Kontaktflächen mittels des elektrischen Leitmediums miteinander kontaktiert sind. Beispielsweise wird das elektrische Leitmedium derart aufgeweicht, dass dieses in einem flüssigen Zustand vorliegt. Insbesondere ist das elektrische Leitmedium ein sogenanntes Preform- oder Einlegeteil. Beispielsweise ist das elektrische Leitmedium aus einem Lot erstellt und insbesondere ein "Lot-Preform". Zur Herstellung wird das Preform vorzugsweise in den wannenförmigen Isolationskörper eingelegt.

Das elektrische Leitmedium wird mittels des Isolationskörpers in der gewünschten Form gehalten oder vor Erstarrung in eine gewünschte Form gebracht, weswegen eine vergleichsweise große Menge an elektrischem Leitmedium verwendet werden kann. Infolgedessen weist die elektrische Schaltung eine vergleichsweise hohe Stromtragfähigkeit und eine vergleichsweise große Zuverlässigkeit auf. Zudem ist die Temperaturbeständigkeit erhöht, da aufgrund der vergleichsweise großen Menge an elektrischem Leitmedium eine Erhitzung auch bei einem großen Stromfluss vergleichsweise gering ist. Der Isolationskörper kann hierbei im Wesentlichen frei geformt werden, und das elektrische Leitmedium füllt den Isolationskörper zumindest teilweise aus. Somit ist eine Designflexibilität erhöht. Auch ist ein Bauraum verringert. Zudem sind aufgrund der vergleichsweise geringen Anzahl an Arbeitsschritten Herstellungskosten reduziert.

Beispielsweise wird als elektrisches Leitmedium eine Legierung herangezogen, die beispielsweise Gallium oder Indium oder Zinn umfasst. Mit anderen Worten weist das elektrische Leitmedium zumindest zwei Komponenten auf, von denen eine Gallium, Indium oder Zinn ist. Insbesondere umfasst die Legierung sowohl Gallium als auch Indium sowie Zinn. Geeigneterweise besteht die Legierung aus diesen drei Komponenten. Insbesondere besteht die Legierung zu 65% bis 96% aus Gallium, zu 5% bis 22% aus Indium und zu 0% bis 11% aus Zinn, wobei vorzugsweise zumindest ein nicht vernachlässigbarer Anteil an Zinn vorhanden ist, der größer als eine übliche Verunreinigung ist. Vorzugsweise ist der Anteil an Zinn größer als 1% des Gesamtgewichts. Die genannten Prozentanteile sind insbesondere Gewichtsprozente. Eine derartige Legierung ist unter dem Namen "Galinstan" bekannt. Eine derartige Legierung ist auch bei Zimmertemperatur flüssig, sodass der Isolationskörper mit einem flüssigen elektrischen Leitmedium befüllt ist, sofern die elektrische Schaltung bei Zimmertemperatur oder zumindest Temperaturen oberhalb von - 19°C verwendet wird. Auf diese Weise ist eine Verarbeitung vereinfacht.

Das elektrische Leitmedium wird beispielsweise mit einer Temperatur zwischen 0°C und 100°C, zwischen 10°C und 50°C, beispielsweise bei einer Temperatur zwischen 15°C und 35°C in den Isolationskörper eingefüllt. Infolgedessen ist eine physikalische Belastung des Isolationskörpers verringert, insbesondere aufgrund einer übermäßigen Temperatur, weswegen vergleichsweise kostengünstige Materialien zur Erstellung des Isolationskörpers verwendet werden können. In einer weiteren Alternative ist das elektrische Leitmedium beispielsweise pastenförmig und umfasst elektrisch leitfähige Partikel, beispielsweise kohlenstoffhaltige Partikel oder metallische Partikel, die insbesondere in einem Binder gelöst sind. Auch hier ist eine thermische Belastung des Isolationskörpers verringert.

Geeigneterweise wird als elektrisches Leitmedium ein Medium mit einer elektrischen Leitfähigkeit herangezogen, die geringer als die elektrische Leitfähigkeit von Kupfer ist, also die geringer als 58 x 10⁶ S/m (Siemens pro Meter) ist. Beispielsweise ist die Leitfähigkeit kleiner als die Hälfte der elektrischen Leitfähigkeit von Kupfer. Somit kann ein vergleichsweise kostengünstiges elektrisches Leitmedium herangezogen werden. Da der elektrische Widerstand aufgrund der elektrischen Leitfähigkeit sowie der geometrischen Abmessungen bestimmt ist, kann auch ein vergleichsweise geringer ohmscher Widerstand mittels einer vergleichsweise großen Ausdehnung erstellt werden. Da mittels des Isolationskörpers die geometrische Gestaltung des elektrischen Leitmediums im Wesentlichen frei gewählt werden kann, kann diese vergleichsweise groß gewählt werden. Es können somit auch Bereiche mittels des Isolationskörpers und daher auch mittels des elektrischen Leitmediums ausgefüllt werden, die mechanisch vergleichsweise schwer zugänglich sind, und die beispielsweise zwischen zwei Bauteilen oder im Bereich eines Hinterschnitts liegen. Aufgrund der vergleichsweise großen Ausdehnung wird ein elektrischer Widerstand reduziert, weswegen auch das elektrische Leitmedium mit der vergleichsweise geringen Leitfähigkeit herangezogen werden kann, ohne dass bei Betrieb der elektrischen Schaltung ein übermäßiger ohmscher Widerstand und somit ein übermäßiger Verlust und folglich eine übermäßige Temperaturentwicklung vorliegt.

Beispielsweise wird das elektrische Leitmedium nach Einfüllen in den Isolationskörper ausgehärtet. Dies erfolgt vorzugsweise mittels Zugabe eines weiteren chemischen Elements, sodass sich die chemische Zusammensetzung des elektrischen Leitmediums ändert. Insbesondere wird hierbei ein zusätzliches Metall hinzugefügt. Beispielsweise wird vor Einfüllen in den Isolationskörper das elektrische Leitmedium erhitzt und in einen (zäh-)flüssigen Aggregatszustand überführt. Nach Einfüllen in den Isolationskörper wird das elektrische Leitmedium bevorzugt erneut abgekühlt, sodass dieses wiederum in den festen Aggregatszustand wechselt, wobei jedoch der Isolationskörper mittels des elektrischen Leitmediums ausgefüllt ist. Auf diese Weise ist eine Robustheit erhöht. In einer weiteren Alternative verbleibt das elektrische Leitmedium auch nach dem Einfüllen flüssig und ist insbesondere ein sogenanntes Flüssigmetall. Geeigneterweise ist in diesem Fall das elektrische Leitmedium Galinstan. Hierbei wird mittels des Isolationskörpers ein Entweichen des elektrischen Leitmediums verhindert.

Mittels des Isolationskörpers wird ein Kurzschluss aufgrund eines ungewollten mechanischen Kontakts vermieden. Auch wird eine Ausbildung eines Lichtbogens zwischen dem elektrischen Leitmedium und weiteren Bestandteilen bei einem sonstigen Bauteil vermieden. Beispielsweise wird der Isolationskörper mittels Gießen erstellt, vorzugsweise mittels Kunststoff-Spritzgießens. Geeigneterweise wird das den Isolationskörper bildende Material in eine Form eingefüllt, die beispielsweise auf dem Schaltungsträger angeordnet ist. Alternativ hierzu wird der Isolationskörper separat zu dem Schaltungsträger gefertigt und erst nach vollständiger Erstellung auf den Schaltungsträger aufgebracht und insbesondere an diesem angebunden. Beispielsweise wird hierbei ein sogenannter verlorener Kern verwendet. Mit anderen Worten weist die Form einen Kern auf, der im Zuge der Herstellung des Isolationskörpers zerstört wird, insbesondere aufgeschmolzen wird. Infolgedessen kann die Form des Isolationskörpers vergleichsweise frei gewählt werden, sodass auch das elektrische Leitmedium der fertig erstellten elektrischen Schaltung die frei gewählte Form aufweist.

In einer weiteren Alternative wird der Isolationskörper mittels 3D-Druckens erstellt. Mit anderen Worten wird ein sogenannter 3D-Drucker zur Erstellung des Isolationskörpers herangezogen, wobei der Isolationskörper vorzugsweise auf den Schaltungsträger gedruckt wird. Auch mittels dieses Verfahrens kann die Form des Isolationskörpers vergleichsweise frei gewählt werden.

Vorzugsweise wird ein Isolationskörper mit einer Öffnung gewählt, wobei die Öffnung beispielsweise eine Einfüllöffnung ist. Über die Einfüllöffnung wird das elektrisch leitfähige Medium in den Isolationskörper eingefüllt, was die Herstellung vereinfacht. Alternativ ist die Öffnung eine Entlüftungsöffnung, durch die bei Befüllung des Isolationskörpers Luft oder ein sonstiges Gas, welches sich innerhalb des Isolationskörpers befindet, entweichen kann, sodass eine mechanische Belastung des Isolationskörpers verringert ist. Vorzugsweise weist der Isolationskörper zumindest eine Einfüllöffnung sowie eine Entlüftungsöffnung auf. Besonders bevorzugt wird die Öffnung, also insbesondere die Einfüllöffnung bzw. die Entlüftungsöffung, geeigneterweise sämtliche Öffnungen des Isolationskörpers, also vorzugsweise sowohl die Einfüllöffnung als auch die Entlüftungsöffnung, bzw. die Einfüllöffnungen und/oder die Entlüftungsöffnungen, nach Einfüllen des elektrischen Leitmediums verschlossen. Die beiden Aussparungen im Bereich der beiden Kontaktflächen bleiben bevorzugt geöffnet. Aufgrund des Verschließens ist ein Austritt des elektrischen Leitmediums aus dem Isolationskörper unterbunden, weswegen eine vergleichsweise robuste elektrische Schaltung erstellt wird. Sofern das elektrische Leitmedium in einem flüssigen oder zumindest viskosen Zustand verbleibt, ist somit ein Austritt verhindert, weswegen eine Zuverlässigkeit und Robustheit der elektrischen Schaltung erhöht ist.

In einer Alternative wird ein wannenartiger Isolationskörper herangezogen, der somit nach Art einer Wanne oder Rinne gefertigt ist. Mit anderen Worten weist der Isolationskörper zumindest über einen vergleichsweise großen Abschnitt, beispielsweise über die Hälfte dessen Länge einen im Wesentlichen U-förmigen Querschnitt auf, wobei die aufgrund der U-Form gebildete Öffnung vorzugsweise von dem Schaltungsträger weggerichtet ist. Aufgrund einer derartigen Ausgestaltung des Isolationskörpers ist ein Einfüllen des elektrischen Leitmediums vereinfacht. Auch kann auf diese Weise sichergestellt werden, dass der Isolationskörper über vergleichsweise weite Bereiche mit dem elektrischen Leitmedium befüllt wird, und dass nicht beispielsweise aufgrund von Fertigungstoleranzen ein Fließen des elektrischen Leitmediums in bestimmte Bereiche aufgrund einer ungewollten Verschmutzung o.dgl. verhindert wird.

Vorzugsweise wird im Anschluss an das Einfüllen (Einbringen) des elektrischen Leitmediums in den Isolationskörper dieser mittels eines Deckels verschlossen. Geeigneterweise ist der Deckel derart ausgestaltet, dass nach dem Verschließen das elektrische Leitmedium im Wesentlichen vollständig mittels des Isolationskörpers und mittels des Deckels sowie mittels der beiden Kontaktflächen umgeben ist. Infolgedessen ist ein Austritt des elektrischen Leitmediums aus dem Isolationskörper im Wesentlichen unterbunden, auch falls das elektrische Leitmedium in einem flüssigen Zustand verbleibt. Zudem wird ein elektrischer Kurzschluss vermieden.

In einer weiteren Alternative ist der Isolationskörper mit Ausnahme der den Kontaktflächen zugeordneten Aussparungen vollständig geschlossen. Das elektrische Leitmedium wird in den Isolationskörper injiziert, beispielsweise mittels einer Nadel. Hierbei wird der Isolationskörper mittels der Injiziervorrichtung partiell geöffnet, wobei der Isolationskörper in diesem Bereich elastisch vorzugsweise verformt wird. Nach Einfüllen des elektrischen Leitmediums wird die Injiziervorrichtung entfernt und der Isolationskörper wird im Bereich der Öffnung verschlossen, wobei dies vorzugsweise aufgrund einer Relaxation des Mediums des Isolationskörpers insbesondere selbständig erfolgt. Beispielsweise ist das Material des Isolationskörpers hierauf abgestimmt. In einer Alternative ist eine Entlüftungsöffnung vorgesehen, sodass etwaige innerhalb des Isolationskörpers vorhandene Luft oder ein sonstiges gasförmiges Medium, entweichen kann. In einer weiteren Alternative wird der Isolationskörper aufgrund des Injizierens des elektrischen Leitmediums aufgebläht, wobei vor Einfüllen des elektrischen Leitmediums innerhalb des Isolationskörpers beispielsweise kein Volumen oder lediglich ein vergleichsweise geringes Volumen vorhanden ist, das beispielsweise kleiner oder gleich einem Zehntel, 5% oder 1% des elektrischen Leitmediums entspricht.

Ein weiteres Verfahren zur Herstellung der elektrischen Schaltung sieht vor, dass zunächst der Schaltungsträger mit der ersten Kontaktfläche und mit der zweiten Kontaktfläche bereitgestellt wird. Dieser Schaltungsträger entspricht vorzugsweise dem Schaltungsträger des vorhergehenden Verfahrens. Mit anderen Worten ist der Schaltungsträger beispielsweise eine DCB, eine Leiterplatte oder umfasst zumindest diese oder ein MID ("Molded Interconnect Device"). Insbesondere umfasst der Schaltungsträger zumindest ein elektrisches bzw. elektronisches Bauteil, welches beispielsweise ein Halbleiterschalter und/oder Leistungshalbleiter ein ist, geeigneterweise ein Leistungshalbleiterschalter oder eine Diode. Das Bauteil ist beispielsweise mittels Sintern, Kleben oder Löten an weiteren Bestandteilen des Schaltungsträgers angebunden. Die beiden Kontaktflächen sind vorzugsweise zueinander parallel und insbesondere zueinander beabstandet. Geeigneterweise sind die beiden Kontaktflächen zueinander versetzt, zum Beispiel senkrecht zu einer Ebene, innerhalb derer zumindest eine der beiden Kontaktflächen angeordnet ist. Vorzugsweise sind die beiden Kontaktflächen zueinander elektrisch isoliert.

In einem weiteren Arbeitsschritt wird ein festes elektrisches Leitmedium auf den Schaltungsträger aufgesetzt. Beispielsweise liegt das elektrische Leitmedium auf einer Isolierung des Schaltungsträgers auf. Vorzugsweise überdeckt das feste elektrische Leitmedium die erste und/oder zweite Kontaktfläche, wobei diese nicht zwangsweise berührt werden müssen. Geeigneterweise wird das feste elektrische Leitmedium zumindest teilweise auf die erste Kontaktfläche aufgesetzt. Beispielsweise wird das elektrische Leitmedium zusätzlich auf die zweite Kontaktfläche zumindest teilweise aufgesetzt, sodass das elektrische Leitmedium elektrisch sowohl mit der ersten Kontaktfläche als auch mit der zweiten Kontaktfläche in mechanischem direktem Kontakt steht. Vorzugsweise sind auf diese Weise die beiden Kontaktflächen elektrisch kontaktiert. Zumindest jedoch ist das elektrische Leitmedium in mechanisch direktem Kontakt mit der ersten Kontaktfläche und folglich elektrisch mit dieser kontaktiert. Das feste elektrische Leitmedium ist beispielsweise quaderförmig ausgestaltet oder weist eine sonstige, willkürliche oder bestimmte Form auf. Insbesondere ist das elektrische Leitmedium ein sogenanntes Preform- oder Einlegeteil. Beispielsweise ist das elektrische Leitmedium aus einem Lot erstellt und insbesondere ein "Lot-Preform".

In einem weiteren Arbeitsschritt wird das elektrische Leitmedium zumindest teilweise aufgeweicht, sodass dieses in einen fließfähigen Zustand übergeht. Insbesondere wird das Leitmedium erwärmt, wobei die Erwärmung unterhalb einer Zersetzungstemperatur gehalten wird. Insbesondere wird das elektrische Leitmedium nicht vollständig in den flüssigen Zustand überführt, sondern lediglich partiell aufgeweicht, sodass dieses eine erhöhte Viskosität aufweist. Die Aufweichung ist derart, dass das elektrische Leitmedium zumindest teilweise die erste Kontaktfläche und zumindest teilweise die zweite Kontaktfläche überdeckt, sodass die beiden Kontaktflächen mittels des elektrischen Leitmediums elektrisch kontaktiert sind. Das elektrische Leitmedium passt sich der Oberfläche der beiden Kontaktflächen an und liegt vorzugsweise großflächig an dem Schaltungsträger an, der beispielsweise mit einer elektrischen Isolierung zumindest abschnittsweise versehen ist. Insbesondere erfolgt eine Änderung der Form des elektrischen Leitmediums, und dieses wird beispielsweise in mittels des Schaltungsträgers bereitgestellte Zwischenräume eingefüllt.

In einem weiteren Arbeitsschritt wird das elektrische Leitmedium ausgehärtet, wobei das elektrische Leitmedium bevorzugt abgekühlt wird. Infolgedessen liegt das elektrische Leitmedium erneut in dem festen Zustand vor. In einem weiteren Arbeitsschritt wird das elektrische Leitmedium mit einem Isolationskörper zumindest teilweise umgeben. Der Isolationskörper wird aus einem elektrisch isolierenden Material erstellt, insbesondere einem Kunststoff oder einem Silikon. Beispielsweise wird der Isolationskörper auf das elektrische Leitmedium aufgesprüht oder mittels 3D-Druck aufgetragen. Geeigneterweise wird das elektrische Leitmedium im Wesentlichen vollständig, mit Ausnahme des mechanischen Kontakts mit dem Schaltungsträger, insbesondere mit Ausnahme des mechanischen Kontakts mit den beiden Kontaktflächen, mittels des Isolationskörpers umgeben, sodass alle nicht an dem Schaltungsträger anliegenden Oberflächen mittels des Isolationskörpers umgeben sind. Infolgedessen ist ein elektrischer Kurzschluss bei Betrieb verhindert.

Auch bei dieser Herstellungsart kann ein elektrisches Leitmedium mit einer vergleichsweise großen Masse herangezogen werden, sodass ein elektrischer Widerstand und somit ein elektrischer Verlust, der zu einer Temperaturerhöhung führt, vergleichsweise gering ist. Zudem passt sich das elektrische Leitmedium der Oberfläche des Schaltungsträgers an. Infolgedessen wird das elektrische Leitmedium mittels der Oberfläche des Schaltungsträgers stabilisiert, was eine Zuverlässigkeit erhöht. Auch wird ein Bauraum reduziert, sodass die Flexibilität erhöht ist. Ferner sind vergleichsweise wenige Arbeitsschritte zur Herstellung erforderlich, was Herstellungskosten reduziert. Zudem muss das elektrische Leitmedium nicht speziell gefertigt werden, was Herstellungskosten weiter reduziert.

Bevorzugt weist das elektrische Leitmedium vor dem Aufsetzen auf den Schaltungsträger einen Abschnitt auf, an dem ein Werkzeug angreifen kann, sodass das Aufsetzen auf den Schaltungsträger vereinfacht ist. Insbesondere wird dieser Abschnitt aufgrund des Aufweichens verringert oder ganz entfernt, weswegen der Bauraum der elektrischen Schaltung verringert ist. Aufgrund des Abschnitts ist eine Herstellung vereinfacht.

Die elektrische Schaltung umfasst einen Schaltungsträger, der eine erste Kontaktfläche und eine zweite Kontaktfläche aufweist. Der Schaltungsträger ist beispielsweise eine Leiterplatte oder ein MID, und die erste Kontaktfläche und/oder die zweite Kontaktfläche sind zumindest teilweise mittels einer Leiterbahn oder eines Abschnitts einer Leiterbahn gebildet. Insbesondere ist die erste Kontaktfläche und/oder die zweite Kontaktfläche mittels einer Kupferbahn gebildet. Besonders bevorzugt ist zumindest eine der Kontaktflächen mittels eines Anschlusses eines elektrischen und/oder elektronischen Bauteils gebildet, das auf weitere Bestandteile des Schaltungsträgers, wie einem mit einer Leiterbahn verbundenen Anschlusspad, aufgesetzt und insbesondere elektrisch mit diesem kontaktiert ist. Die beiden Kontaktflächen sind vorzugsweise zueinander parallel, insbesondere zueinander versetzt, angeordnet und befinden sich geeigneterweise auf der gleichen Seite des Schaltungsträgers. Vorzugsweise sind die beiden Kontaktflächen mechanisch zueinander beabstandet.

Die beiden Kontaktflächen sind mittels eines elektrischen Leitmediums elektrisch miteinander kontaktiert, das zumindest teilweise mittels eines Isolationskörpers umgeben ist. Das elektrische Leitmedium ist beispielsweise fest oder flüssig. Insbesondere ist das elektrische Leitmedium fließfähig, also geeigneterweise viskos, zumindest bei Betriebstemperatur der elektrischen Schaltung. Der Isolationskörper ist beispielsweise aus einem Kunststoff oder einem Silikon gefertigt.

Vorzugsweise ist die elektrische Schaltung nach einem Verfahren gefertigt, bei dem in einem Arbeitsschritt der Schaltungsträger mit den Kontaktflächen bereitgestellt wird. In einem weiteren Arbeitsschritt wird der Isolationskörper auf den Schaltungsträger aufgebracht, wobei der Isolationskörper die erste Kontaktfläche und mindestens eine zweite Kontaktfläche zumindest teilweise überdeckt, und wobei der Isolationskörper im Bereich der beiden Kontaktflächen jeweils eine Aussparung aufweist. In einem weiteren Arbeitsschritt wird in den Isolationskörper das fließfähige elektrische Leitmedium eingefüllt.

Ein anderes Verfahren zur Herstellung der elektrischen Schaltung sieht vor, dass zunächst der Schaltungsträger mit der ersten und mindestens einer zweiten Kontaktfläche bereitgestellt wird. In einem weiteren Arbeitsschritt wird das feste elektrische Leitmedium zumindest teilweise auf die erste Kontaktfläche, insbesondere zumindest teilweise auf die zweite Kontaktfläche, aufgesetzt. In einem weiteren Arbeitsschritt wird das elektrische Leitmedium derart in einen zumindest teilweise fließfähigen Zustand aufgeweicht, dass das elektrische Leitmedium zumindest teilweise die erste Kontaktfläche und zumindest teilweise die zweite Kontaktfläche überdeckt. Mit anderen Worten fließt ein Bestandteil des elektrischen Leitmediums auf die erste Kontaktfläche und die zweite Kontaktfläche. In einem weiteren Arbeitsschritt wird das elektrische Medium ausgehärtet. In einem weiteren Arbeitsschritt wird das elektrische Medium ausgehärtet, sodass dieses wiederum in den festen Zustand überführt wird. In einem weiteren Arbeitsschritt wird das elektrische Leitmedium zumindest teilweise mit dem Isolationskörper umgeben.

Die im Zusammenhang mit den Verfahren zur Herstellung der elektrischen Schaltung gemachten Ausführungen und Weiterbildungen sind sinngemäß auch auf die elektrische Schaltung zu übertragen und umgekehrt.

Ausführungsbeispiele der Erfindung werden anhand einer Zeichnung näher erläutert. Darin zeigen:
- FIG 1: Schematisch eine elektrische Schaltung in einer Draufsicht,
- FIG 2: ein Verfahren zur Herstellung einer elektrischen Schaltung,
- FIG 3 - 8: jeweils in einer seitlichen Schnittdarstellung die elektrische Schaltung in Zwischenstadien der Herstellung,
- FIG 9: ein weiteres Verfahren zur Herstellung einer elektrischen Schaltung, und
- FIG 10 - 13: jeweils in einer seitlichen Schnittdarstellung die elektrische Schaltung in Zwischenstadien der Herstellung.

Einander entsprechende Teile sind in allen Figuren mit dem gleichen Bezugszeichen versehen.

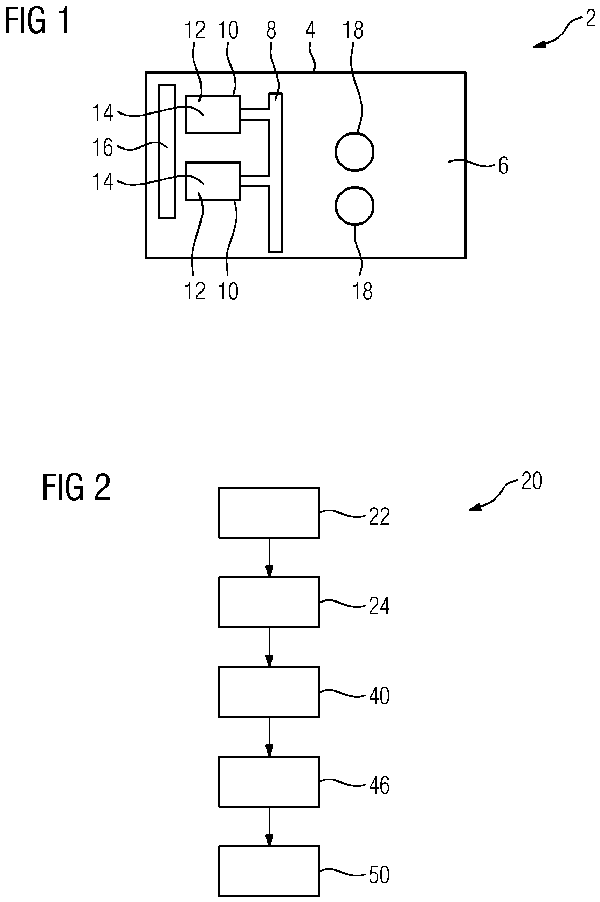

In FIG 1 ist in einer Draufsicht schematisch eine elektrische Schaltung 2 dargestellt, die ein Bestandteil eines nicht näher gezeigten Wechselrichters ist. Die elektrische Schaltung 2 weist einen Schaltungsträger 4 auf, der ein Substrat 6 umfasst, welches aus einem glasfaserverstärkten Epoxidharz oder in weiteren Alternativen aus Keramik (DCB) oder thermoplastischem Kunststoff (MID) erstellt ist. An der Oberfläche des Substrats 6 ist eine Leiterbahn 8 angebunden, die aus einem Kupfer oder einem sonstigen elektrisch leitfähigen Material, wie z. B. Silber oder Gold, erstellt ist. Mit der Leiterbahn 8 sind zwei Leistungshalbleiter 10, wie Leistungshalbleiterschalter oder eine Dioden, mittels SMD-Technik angelötet und somit mit der Leiterbahn 8 sowohl mechanisch als auch elektrisch kontaktiert. Alternativ sind die Leistungshalbleiter 10 mittels Sintern, Kleben oder Löten an der Leiterbahn 8 angebunden, wobei beispielsweise eine THD-Technik herangezogen wird.

Die Leistungshalbleiter 10 weisen auf der dem Substrat 6 abgewandten Seite jeweils einen Anschluss 12 auf, der in nicht näher dargestellter Weise mit einer weiteren Leiterbahn elektrisch kontaktiert ist. Die Leiterbahn 8 bildet eine erste Kontaktfläche 14, und jeder Anschluss 12 bildet eine zweite Kontaktfläche 16. Hierbei liegen die Kontaktflächen 14,16 in unterschiedlichen Ebenen und sind zueinander parallel. Der Schaltungsträger 4 weist ferner weitere elektrische bzw. elektronische Bauteile 18 auf, die mit weiteren, nicht näher dargestellten Leiterbahnen elektrisch kontaktiert sind. Die Bauteile 18 sind beispielsweise Kondensatoren.

In FIG 2 ist ein Verfahren 20 zur Herstellung der elektrischen Schaltung 2 dargestellt. In einem ersten Arbeitsschritt 22 wird der Schaltungsträger 4 mit der ersten Kontaktfläche 14 und der zweiten Kontaktfläche 16 bereitgestellt. Hierfür wird zunächst das Substrat 6 sowie die Leiterbahn 8 als die erste Kontaktfläche 14 gefertigt, an denen die Leistungshalbleiter 10 mittels SMD-Technik oder eine anderweitigen Technik angebunden werden.

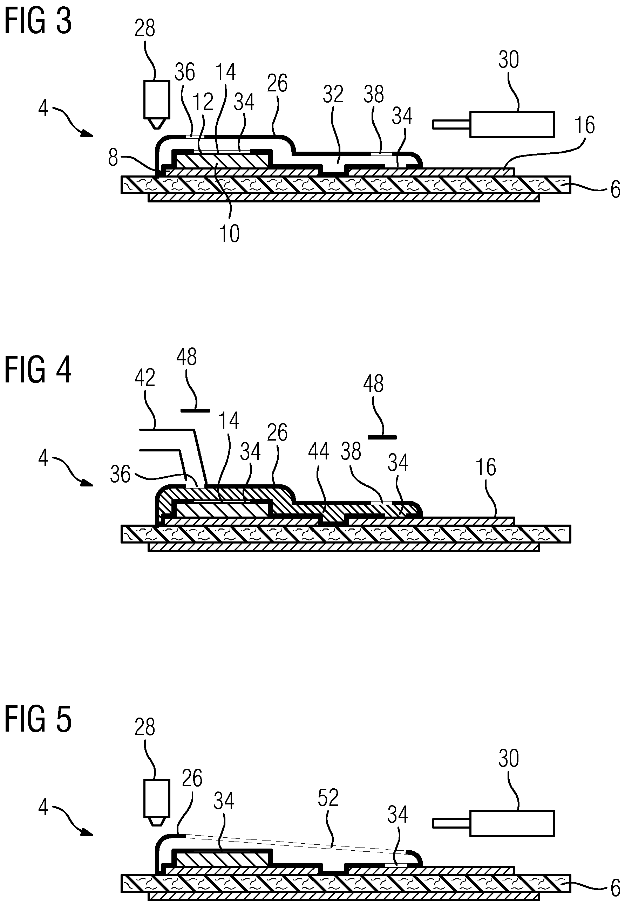

In einem zweiten Arbeitsschritt 24 wird ein Isolationskörper 26 aus einem Kunststoff oder einem Silikon auf den Schaltungsträger 4 aufgebracht. Der Isolationskörper 26 wird hierbei beispielsweise separat von dem Schaltungsträger 6 gefertigt oder direkt auf diesem erstellt. Der Isolationskörper 26 wird mittels eines 3D-Druckers 28 auf den Schaltungsträger 4 gedruckt. In einer Alternative hierzu wird eine Gießvorrichtung 30 herangezogen. Der Isolationskörper 26 ist ein Hohlkörper, und zum Gießen des Isolationskörpers 26 mittels der Gießvorrichtung 30 wird ein sogenannter verlorener Kern herangezogen, der bei dem Gießen des Isolationskörpers 26 zerstört wird, wobei ein Hohlraum 32 des Isolationskörpers 26 erstellt wird, wie in FIG 3 gezeigt. Der Isolationskörper 26 überdeckt die erste Kontaktfläche 14 und die zweite Kontaktfläche 16 zumindest teilweise, wobei der Isolationskörper 26 im Bereich der beiden Kontaktflächen 14,16 jeweils eine Aussparung 34 aufweist. Die beiden Aussparungen 34 sind mittels der jeweils zugeordneten Kontaktfläche 14,16 verschlossen. Der Isolationskörper 26 weist ferner eine Einfüllöffnung 36 und eine Entlüftungsöffnung 38 auf, die sich auf der dem Schaltungsträger 4 abgewandten Seite des Isolationskörpers 26 befinden. Jedem der Leistungshalbleiter 10 wird hierbei jeweils ein Isolationskörper 26 zugeordnet, wobei die beiden Isolationskörper 26 zueinander beabstandet sind. In einer weiteren Alternative reicht der Isolationskörper 26 über mehrere Leistungshalbleiter 10, beispielsweise zwei Leistungshalbleiter 10, insbesondere bei einer Halbbrücke.

In einem dritten Arbeitsschritt 40 wird mittels einer Einfüllvorrichtung 42, die beispielsweise eine Düse ist, ein fließfähiges elektrisches Leitmedium 44 durch die Einfüllöffnung 36 in den Isolationskörper 26 eingefüllt, welches auch in die Aussparungen 34 des Isolationskörpers 26 läuft. Sich in dem Hohlraum 32 befindende Luft tritt durch die Entlüftungsöffnung 38 aus. Das elektrische Leitmedium 44 füllt den Isolationskörper 26 im Wesentlichen vollständig aus. Das elektrische Leitmedium 44 ist eine Legierung, die eine elektrische Leitfähigkeit aufweist, die kleiner als die Hälfte der elektrischen Leitfähigkeit von Kupfer und beispielsweise im Wesentlichen gleich einem Viertel der elektrischen Leitfähigkeit von Kupfer ist. Das elektrische Leitmedium 44 liegt bei Zimmertemperatur in einem festen Aggregatszustand vor und ist vor Einfüllen erhitzt worden, wobei die Erhitzung jedoch geringer als die Zersetzungstemperatur des elektrischen Leitmediums 44 und geringer als die Zersetzungstemperatur des Isolationskörpers 26 ist.

In einem vierten Arbeitsschritt 46 werden die Einfüllöffnung 36 und die Entlüftungsöffnung 38 jeweils mittels einer Kappe 48 verschlossen, sodass ein Austritt des elektrischen Leitmediums 44 aus dem Isolationskörper 26 unterbunden ist. Die Kappen 48 sind aus dem gleichen Material wie der Isolationskörper 26 erstellt und werden bevorzugt ebenfalls mittels 3D-Drucks oder Gießen gefertigt. In einem sich anschließenden fünften Arbeitsschritt 50 wird das elektrische Leitmedium 44 ausgehärtet. Hierfür wird dieses abgekühlt. In einer weiteren Alternative wird das elektrische Leitmedium 44 bei offenen Öffnungen 36, 38 aushärtet. Hierbei wird insbesondere auf die Kappen 48 verzichtet, und die Öffnungen 36, 38 bleiben bestehen. Alternativ werden auch in diesem Fall anschließend die Öffnungen 36, 38 mittels der Kappen 48 verschlossen

Die Kappen 48 sind in einer weiteren Alternativ nicht aus dem gleichen Material wie der Isolationskörper 26. Die Kappen 48 sind in weiteren Alternativen als Halbzeug (Pfropfen) bereitgestellt und nicht per 3D-Druck oder Gießen hergestellt. Der fünfte Arbeitsschritt 50 kann auch komplett entfallen, wenn durch die Kappen 48 das elektrische Leitmedium 44 eingeschlossen bleibt.

Mittels des elektrischen Leitmediums 44 sind die erste Kontaktfläche 14 sowie die zweite Kontaktfläche 16 elektrisch miteinander kontaktiert, wobei der Isolationskörper 26 und über diesen somit das elektrische Leitmedium 44 vergleichsweise großflächig an dem Schaltungsträger 4 anliegt, sodass dieses mittels des Schaltungsträgers 4 stabilisiert ist. Infolgedessen ist eine Zuverlässigkeit erhöht und es kann auch eine vergleichsweise große Menge des elektrischen Leitmediums 44 herangezogen werden, weswegen ein elektrischer Widerstand vergleichsweise gering ist, was die Temperaturbeständigkeit erhöht.

Sofern bei Betrieb das elektrische Leitmedium 44 erneut in den flüssigen Zustand überführt wird, erfolgt ein sogenannter Selbstheilungsprozess, sodass auch eine vergleichsweise lange Betriebsdauer der elektrischen Schaltung 2 ermöglicht ist. Auch wird eine mögliche maximale Einsatztemperatur nicht aufgrund des elektrischen Leitmediums 44 begrenzt, sondern lediglich aufgrund der maximalen Einsatztemperatur des Isolationskörpers 26.

In FIG 5 ist gemäß FIG 3 eine alternative Ausführungsform des Isolationskörpers 26 gezeigt, der in dem zweiten Arbeitsschritt 24 mittels des 3D-Druckers 28 oder der Gießvorrichtung 30 erstellt wird. Auch dieser Isolationskörper 26 weist die beiden Aussparungen 34 auf und ist entsprechend dem in FIG 3 gezeigten Isolationskörper 26 angeordnet. Der Isolationskörper 26 ist wannenartig ausgestaltet und weist somit auf der dem Schaltungsträger 4 abgewandten Seite eine vergleichsweise große Öffnung 52 auf. Insbesondere weist der Isolationskörper 26, wie hier dargestellt, dort keine Wand auf, sodass der Isolationskörper 26 im Wesentlichen U-förmig ausgestaltet ist.

Auch in diesem Isolationskörper 26 wird in dem dritten Arbeitsschritt 40 das fließfähige elektrische Leitmedium 44 eingefüllt, und nach Einfüllen des elektrischen Leitmediums 44 wird der Isolationskörper 26 mit einem Deckel 54 verschlossen. Der Deckel 54 ist aus dem gleichen Material wie der Isolationskörper 26 erstellt. Ferner wird der fünfte Arbeitsschritt 50 ausgeführt, und das elektrische Leitmedium 44 ausgehärtet. In einer weiteren Alternative härtet das elektrische Leitmedium 44 bei offenem Isolationskörper 26 aus. Hierbei verbleibt der Isolationskörper 26 beispielsweise offen oder wird anschließend mittels des Deckels 54 verschlossen.

Der Deckel 54 muss in weiteren Alternativen nicht aus dem gleichen Material wie der Isolationskörper 26 erstellt. Beispielsweise ist der Deckel 54 als Halbzeug bereitgestellt. Der fünfte Arbeitsschritt 50 kann auch komplett entfallen, wenn durch den Deckel 54 das flüssige elektrische Leitmedium 44eingeschlossen bleibt.

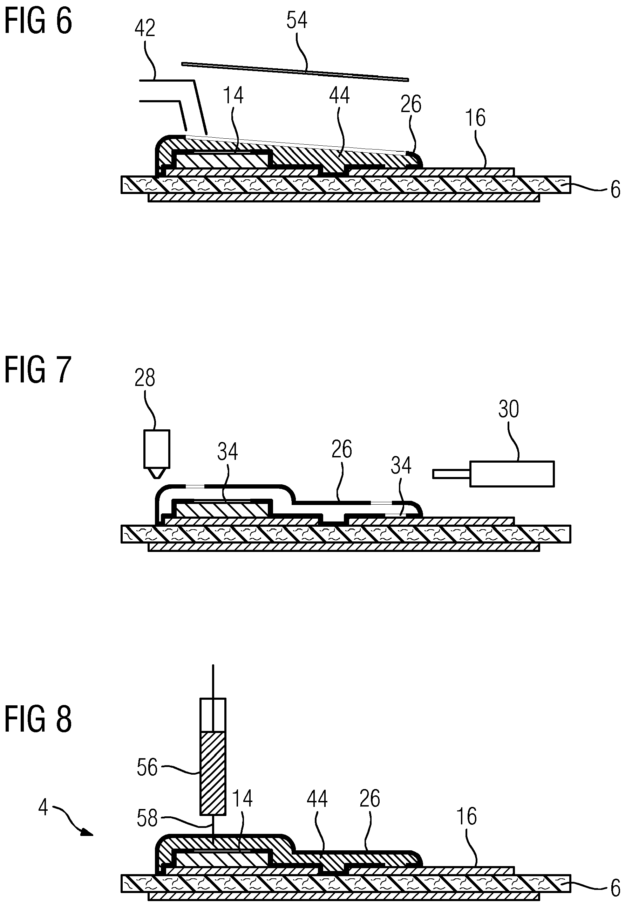

In FIG 7 ist eine weitere Ausgestaltungsform des Isolationskörpers 26 gezeigt, der in dem zweiten Arbeitsschritt 24 mittels des 3D-Druckers 28 oder der Gießvorrichtung 30 erstellt wird, wobei beim Gießen vorzugsweise eine Öffnung vorhanden ist, um den Kern zu entfernen, soweit er nicht verbleiben und durch das elektrische Leitmedium 44 aufgelöst werden kann. Der Isolationskörper 26 weist mit Ausnahme der Aussparungen 34 keine weiteren Öffnungen auf und ist somit geschlossen ausgestaltet. Der Isolationskörper 26 ist wiederum derart angeordnet, dass dieser die erste Kontaktfläche 14 und die zweite Kontaktfläche 16 zumindest teilweise überdeckt, und der Isolationskörper 26 weist im Bereich der beiden Kontaktflächen 14,16 jeweils die Aussparungen 34 auf.

In den Isolationskörper 26 wird, wie in FIG 8 gezeigt, mittels einer Injiziervorrichtung 56 das elektrische Leitmedium 44 injiziert. Hierbei wird der Isolationskörper 26 mittels einer Nadel 58 der Injiziervorrichtung 56 punktuell geöffnet und das elektrische Leitmedium 44 in den Hohlraum 32 gepresst. Nachdem der Isolationskörper 26 mittels des elektrischen Leitmediums 44 ausgefüllt ist, wird die Nadel 58 aus dem Isolationskörper 26 entfernt, und aufgrund einer elastischen Rückverformung des Isolationskörpers 26 wird die punktuelle Öffnung, die mittels der Nadel 58 erstellt wurde, selbständig verschlossen.

In weiteren Ausgestaltungsformen wird ein elektrisches Leitmedium 44 herangezogen, welches auch bei Raumtemperatur in flüssigem Aggregatszustand vorliegt. Zum Aushärten wird in dem fünften Arbeitsschritt 50 ein zusätzlicher Stoff, insbesondere ein Metall, hinzugefügt, sodass die Legierungszusammensetzung des elektrischen Leitmediums 44 geändert wird. Diese Legierung liegt in diesem Fall bei Raumtemperatur in dem festen Aggregatszustand vor. In einer noch weiteren Alternative entfällt der fünfte Arbeitsschritt 50 vollständig, und das elektrische Leitmedium 44 liegt auch bei Raumtemperatur im flüssigen Aggregatszustand vor. Hierbei wird als elektrisches Leitmedium 44 in einer bevorzugten Alternative eine Legierung herangezogen, die Gallium, Indium und Zinn umfasst, wobei der Anteil an Gallium zwischen 65 und 95 Gew.%, der Anteil an Indium zwischen 5% und 22% und der Anteil an Zinn zwischen 0% und 11%, ausgedrückt in Gewichtsprozent, beträgt. Insbesondere wird als Legierung sogenanntes Galinstan verwendet.

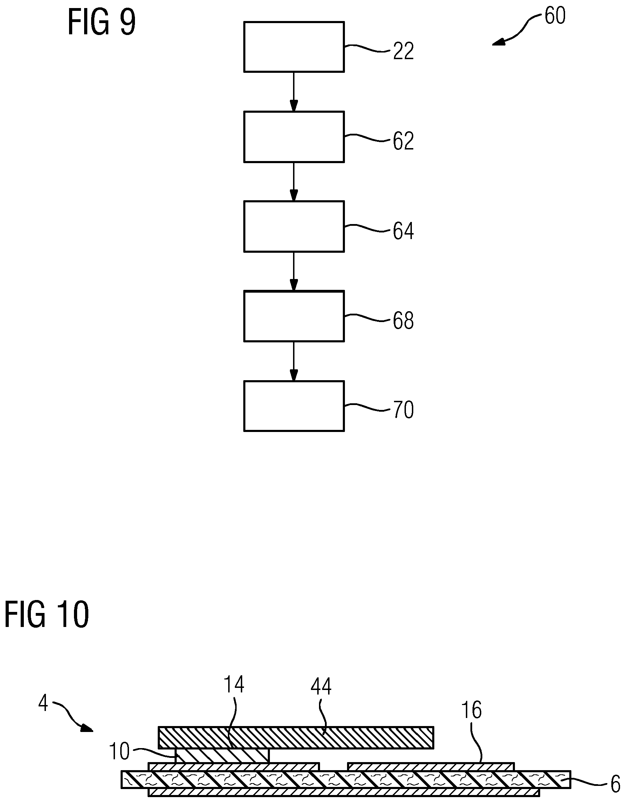

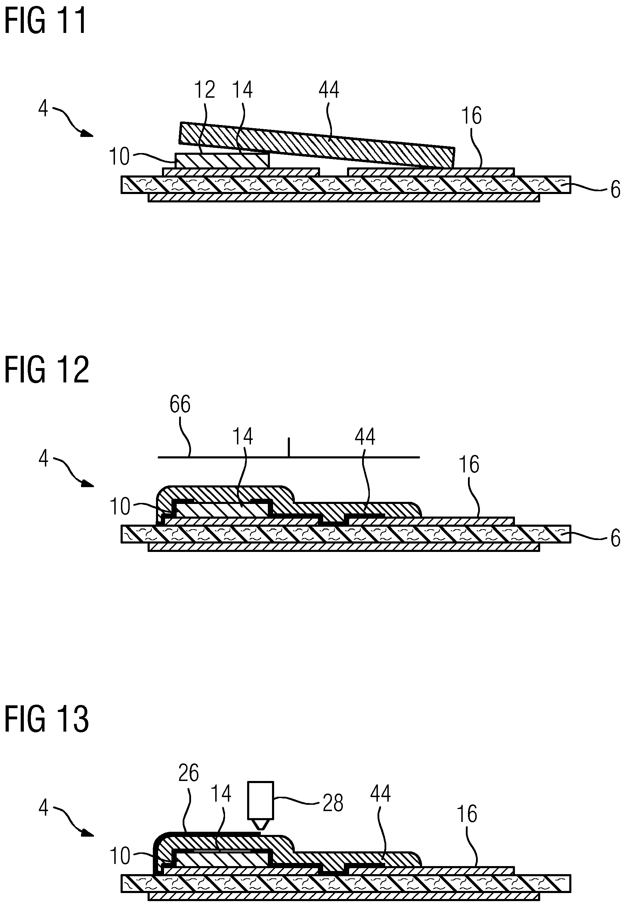

In FIG 9 ist ein weiteres Verfahren 50 zur Herstellung der elektrischen Schaltung 2 gezeigt. Auch hier wird der erste Arbeitsschritt 22 ausgeführt und der Schaltungsträger 4 mit der ersten Kontaktfläche 14 und der zweiten Kontaktfläche 16 bereitgestellt. In einem sich anschließenden sechsten Arbeitsschritt 62 wird das elektrische Leitmedium 44, das in dem festen Aggregatszustand vorliegt, teilweise auf die erste Kontaktfläche 14 aufgesetzt, wobei das elektrische Leitmedium 44 von der zweiten Kontaktfläche 16 beabstandet ist, dieses jedoch bei der Projektion auf das Substrat 6 überdeckt. Die erste Kontaktfläche 14 wird im Wesentlichen vollständig mittels des elektrischen Leitmediums 44 überdeckt. Das elektrische Leitmedium 44 ist ein Lot-Preform, wie in FIG 10 gezeigt. In einer Alternative wird, wie in FIG 11 dargestellt, das elektrische Leitmedium 44 sowohl auf die erste Kontaktfläche 14 als auch auf die zweite Kontaktfläche 16 teilweise aufgesetzt, sodass dieses in direktem mechanischem Kontakt mit den beiden Kontaktflächen 14,16 ist. In einer weiteren Alternative liegt das elektrische Leitmedium 44 anfangs lediglich auf der Isolation auf. Der endgültige Kontakt zu den Kontaktfläche 14 und 16 erfolgt dann in einem weiteren Arbeitsschritt (siebter Arbeitsschritt 64).

In einem siebten Arbeitsschritt 64 wird das elektrische Leitmedium 44 mittels einer Heizvorrichtung 66 aufgeweicht, sodass dieses teilweise in den fließfähigen Zustand übergeht. Hierbei wird das elektrische Leitmedium 44 nicht vollständig verflüssigt, sondern lediglich in einen viskosen Zustand übergeführt. Infolgedessen schmiegt sich das elektrische Leitmedium 44 an den Schaltungsträger 4 an, und mittels des elektrischen Leitmediums 44 wird zumindest teilweise die erste Kontaktfläche 14 und die zweite Kontaktfläche 16 überdeckt. Das elektrische Leitmedium 44 liegt großflächig auf dem Schaltungsträger 4 auf. Entweder liegt hierbei das elektrische Leitmedium 44 mechanisch direkt an dem Schaltungsträger 4 an, oder über etwaige, nicht näher dargestellte Isolierungen, sodass ein ungewollter Kurschluss vermieden ist. Zumindest ist zwischen dem Schaltungsträger 4 und dem elektrischen Leitmedium 44 kein Hohlraum o.dgl. gebildet.

In einem sich anschließenden achten Arbeitsschritt 68 wird das elektrische Leitmedium 44 ausgehärtet, was durch Abkühlen erfolgt. In einem sich anschließenden neunten Arbeitsschritt 70 wird das elektrische Leitmedium 44, welches wiederum in dem festen Aggregatszustand vorliegt, mittels des Isolationskörpers 26 umgeben, der mit dem 3D-Drucker 28 aufgetragen wird. In einer weiteren, nicht näher dargestellten Ausführung erfolgt die Aufbringung des Isolationskörpers 26 mittels Tauchbeschichtung, Sprühens, Dispensens oder Lackierens. Hierbei werden sämtliche Oberflächen mittels des elektrischen Leitmediums 44, die nicht an dem Schaltungsträger 4 anliegen, mit dem Isolationskörper 26 umgeben.

In einer weiteren, nicht näher dargestellten Ausführungsform wird der Isolationskörper 26 entsprechend der in FIG 5 gezeigten Variante erstellt und das elektrische Leitmedium 44 in dem festen Aggregatszustand in den Isolationskörper 26 entsprechend der Anordnung gelegt, die in FIG 10 oder FIG 11 gezeigt ist. Im Anschluss hieran wird das elektrische Leitmedium 44 mittels der Heizvorrichtung 66 erwärmt, sodass dieses den Isolationskörper 26 ausfüllt, wie in FIG 6 gezeigt. Im Anschluss hieran wird der Isolationskörper 26 mit dem Deckel 54 verschlossen.

Zusammenfassend wird der Isolationskörper 26 verwendet, der neben der Funktion als elektrische Isolierung das elektrische Leitmedium 44 aufnimmt und somit stabilisiert. Der Isolationskörper 26 ist als Hohlkörper ausgeführt und dient als Gießkanal, wobei dieser in bestimmten Alternativen die Einfüllöffnung 36, die Entlüftungsöffnung 38 sowie die Aussparungen 34 aufweist. Der Isolationskörper 26 wird bevorzugt mittels Gießen mit verlorenen Kernen oder mittels 3D-Drucks auf dem Substrat 6 erstellt, und die Leistungshalbleiter(-schalter) 10 sind einseitig mittels Sintern, Kleben oder Löten stoffschlüssig auf dem Substrat 6 angebunden. Im Anschluss an das Anbinden erfolgt die Erstellung des Isolationskörpers 26.

Nach Erstellen wird das niederviskose oder flüssige elektrische Leitmedium 44, welches beispielsweise Galinstan ist, oder eine andere, während der Einfüllphase fluide Metalllegierung, in den Isolationskörper 26 eingefüllt, beispielsweise über die Einfüllöffnung 36, oder die Öffnung 52. Das elektrische Leitmedium 44 ist in weiteren Alternativen eine Paste aus Leitpartikeln mit Bindern, welche nach dem Einfüllen aushärten. Nachdem das elektrische Leitmedium 44 eingefüllt ist, kann durch Benetzung und/oder Legierungsbildung an den beiden Kontaktflächen 14,16 ein elektrischer Übergang ausgebildet werden. Auch kann die Kontaktierung über eine Bindervernetzung oder über eine Veränderung der Legierungszusammensetzung erfolgen. Sofern das elektrische Leitmedium 44 auch während des Betriebs im fluiden Zustand verbleibt, wird der Isolationskörper 26 verschlossen, insbesondere mittels der Kappe 48 oder dem Deckel 54. Sofern das elektrische Leitmedium 44 mittels der Injektionsvorrichtung 56 eingefüllt wird, erfolgt aufgrund einer Relaxation des Materials des Isolationskörpers 26 im Bereich der Einführung der Nadel 58 ein selbständiger Verschluss, sodass der Isolationskörper 26 abgedichtet ist.

In einer weiteren Alternative ist der Isolationskörper 26 nach Art einer Wanne aufgebaut, in den das elektrische Leitmedium 44 eingebracht und der anschließend mittels des Deckels 54 überdeckt wird. In einer weiteren Alternative wird als elektrisches Leitmedium 44 ein Lot-Preform oder ein sonstiges Preform/Einlegeteil herangezogen, das mittels thermischer Initiierung mittels der Heizvorrichtung 66 unterhalb der Zersetzungstemperatur des Materials des Isolationskörpers 26 in den schmelzflüssigen Zustand überführt wird, wobei die Oberflächentopographie abgeformt wird, sodass sich das elektrische Leitmedium 44 an die Oberflächentopographie des Schaltungsträgers 6 anschmiegt und den elektrischen Kontakt mit den beiden Kontaktflächen 14,16 ausbildet. Im Anschluss hieran erfolgt die Überdeckung des elektrischen Leitmediums 44 mittels des Isolationskörpers 26, sodass auch beim Aufschmelzen im Betriebsfall das elektrische Leitmedium 44 ortsfest gehalten ist.

Aufgrund des elektrischen Leitmediums 44 wird in vergleichsweise kurzer Zeit ein elektrischer Leiter bereitgestellt, der einen vergleichsweise großen Querschnitt aufweist, und somit eine hohe Stromtragfähigkeit aufweist. Daher kann als elektrisches Leitmedium 44 auch eines mit einer vergleichsweise geringen elektrischen Leitfähigkeit herangezogen werden.

Die Erfindung ist nicht auf die vorstehend beschriebenen Ausführungsbeispiele beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit den einzelnen Ausführungsbeispielen beschriebene Einzelmerkmale auch auf andere Weise miteinander kombinierbar, ohne den Gegenstand der Erfindung zu verlassen.

## Patentansprüche

1. Verfahren (20) zur Herstellung einer elektrischen Schaltung (2), bei dem
- ein Schaltungsträger (4) mit einer ersten Kontaktfläche (14) und mit einer zweiten Kontaktfläche (16) bereitgestellt wird,
- ein Isolationskörper (26) auf den Schaltungsträger (4) aufgebracht wird, wobei der Isolationskörper (26) die erste Kontaktfläche (14) und die zweite Kontaktfläche (16) zumindest teilweise überdeckt, und wobei der Isolationskörper (26) im Bereich der beiden Kontaktflächen (14, 16) jeweils eine Aussparung (34) aufweist, und
- in den Isolationskörper (26) ein fließfähiges elektrisches Leitmedium (44) eingefüllt wird.

2. Verfahren (20) nach Anspruch 1,
**dadurch gekennzeichnet, dass** als elektrisches Leitmedium (44) eine Legierung herangezogen wird, die zumindest teilweise Gallium, Indium und/oder Zinn umfasst.

3. Verfahren (20) nach Anspruch 1 oder 2,
**dadurch gekennzeichnet, dass** als elektrisches Leitmedium (44) ein Medium mit einer elektrischen Leitfähigkeit herangezogen wird, die geringer als die elektrische Leitfähigkeit von Kupfer ist, insbesondere die geringer als die Hälfte der elektrischen Leitfähigkeit von Kupfer ist.

4. Verfahren (20) nach einem der Ansprüche 1 bis 3,
**dadurch gekennzeichnet, dass** das elektrische Leitmedium (44) ausgehärtet wird.

5. Verfahren (20) nach einem der Ansprüche 1 bis 4,
**dadurch gekennzeichnet, dass** der Isolationskörper (26) mittels Gießen oder 3D-Druckens erstellt wird.

6. Verfahren (20) nach einem der Ansprüche 1 bis 5,
**dadurch gekennzeichnet, dass** ein Isolationskörper (26) mit einer Einfüllöffnung (36) und/oder einer Entlüftungsöffnung (38) herangezogen wird, wobei insbesondere die Einfüllöffnung (36) bzw. die Entlüftungsöffnung (38) nach Einfüllen des elektrischen Leitmediums (44) verschlossen wird.

7. Verfahren (20) nach einem der Ansprüche 1 bis 5,
**dadurch gekennzeichnet, dass** ein wannenartiger Isolationskörper (26) herangezogen wird, wobei insbesondere der Isolationskörper (26) nach Einfüllen des elektrischen Leitmediums (44) mit einem Deckel (54) versehen wird.

8. Verfahren (20) nach einem der Ansprüche 1 bis 5,
**dadurch gekennzeichnet, dass** ein mit Ausnahme der den Kontaktflächen zugeordneten Aussparungen (34) geschlossener Isolationskörper (26) herangezogen wird, wobei das elektrische Leitmedium (44) in den Isolationskörper (26) injiziert wird.

9. Verfahren (60) zur Herstellung einer elektrischen Schaltung (2), bei dem
- ein Schaltungsträger (4) mit einer ersten Kontaktfläche (14) und mit einer zweiten Kontaktfläche (16) bereitgestellt wird,
- ein festes elektrisches Leitmedium (44) auf den Schaltungsträger (4) aufgesetzt wird,
- das elektrische Leitmedium (44) in einen zumindest teilweise fließfähigen Zustand derart aufgeweicht wird, dass das elektrische Leitmedium (44) zumindest teilweise die erste Kontaktfläche (14) und zumindest teilweise die zweite Kontaktfläche (16) überdeckt,
- das elektrische Leitmedium (44) ausgehärtet wird, und
- das elektrische Leitmedium (44) mit einem Isolationskörper (26) zumindest teilweise umgeben wird.

10. Elektrische Schaltung (2), die einen Schaltungsträger (4) mit einer erste Kontaktfläche (14) und mit einer zweite Kontaktfläche (16) aufweist, die mittels eines elektrischen Leitmediums (44) elektrisch kontaktiert sind, das zumindest teilweise mittels eines Isolationskörpers (26) umgeben ist, und die insbesondere nach einem Verfahren (20, 60) nach einem der Ansprüche 1 bis 9 erstellt ist.
